# EUROPÄISCHE PATENTSCHRIFT

(11) **EP 3 314 701 B1**
(45) Veröffentlichungstag und Bekanntmachung des Hinweises auf die Patenterteilung: **07.08.2019**
(21) Anmeldenummer: 16728703.6
(22) Anmeldetag: 14.06.2016
(51) Int. Cl.: H01R 13/527, H02G 3/08, H01R 13/52

(54) **ADAPTER FÜR DEN ANSCHLUSS EINER ÜBERTRAGUNGSLEITUNG AN EIN FELDGERÄT**
ADAPTER FOR CONNECTING A TRANSMISSION LINE TO A FIELD DEVICE
ADAPTATEUR POUR LA CONNEXION D'UNE LIGNE DE TRANSMISSION À UN APPAREIL DE TERRAIN

(30) Priorität: 26.06.2015 DE 102015110350
(43) Veröffentlichungstag der Anmeldung: 02.05.2018
(73) Patentinhaber: Endress+Hauser Flowtec AG, 4153 Reinach (CH)
(72) Erfinder: MOSER, Thiérry, 68510 Sierentz (FR); KOLLMER, Daniel, 79689 Maulburg (DE)
(74) Vertreter: Andres, Angelika Maria
(86) Internationale Anmeldenummer: PCT/EP2016/063538
(87) Internationale Veröffentlichungsnummer: WO 2016/207014

(56) Entgegenhaltungen:
- EP-A1- 2 439 818
- WO-A1-2013/172846
- JP-B2- 3 257 427
- US-A1- 2011 014 882

## Beschreibung

Die Erfindung betrifft einen Adapter für den Anschluss einer Übertragungsleitung an ein Feldgerät.

Feldgeräte sind eine Elektronik aufweisende Geräte, die im Feld, insb. in industriellen Anlagen, eingesetzt werden. Hierzu zählen insb. Messgeräte, die eine physikalische Messgröße, z.B. einen Durchfluss, einen Druck oder einen Füllstand, messtechnisch erfassen. Feldgeräte werden z.B. in der industriellen Mess- und Automatisierungstechnik eingesetzt. Dort werden sie unter anderem zur Erfassung von Informationen, insb. von Messwerten und/oder Prozessparametern eingesetzt. Die von einem oder mehreren Feldgeräten erfassten Informationen werden regelmäßig an einen oder mehrere Empfänger übertragen. Die Empfänger sind in der Regel übergeordnete Einheiten, wie z.B. Computer, Steuereinheiten oder Prozessleitsysteme, die die übermittelten Informationen verarbeiten, anzeigen und/oder zur Steuerung und/oder Regelung von Prozessen, wie z.B. industriellen Herstellungs- oder Verarbeitungsverfahren, verwenden. Es gibt aber auch Anwendungen, bei denen Informationen von Feldgerät zu Feldgerät übertragen werden.

Neben der Informationsübertragung vom Feldgerät zum Empfänger ist häufig auch eine Informationsübertragung von einer übergeordneten Einheit zu einem Feldgerät vorgesehen. Hierüber werden z.B. Daten zur Einstellung, Parametrierung und/oder Konfigurierung des Feldgeräts, sowie zur Anpassung des Feldgeräts an von ihm auszuführende Aufgaben, z.B. spezifische Messaufgaben, übertragen.

Die uni- oder bidirektionale Informationsübertragung zwischen einem Feldgerät und einem Empfänger, z.B. einer übergeordneten Einheit oder einem anderen Feldgerät, erfolgt über eine an eine im Feldgerät integrierte Elektronik anzuschließende Übertragungsleitung, über die die Informationen wiedergebende elektrische Signale übertragen werden. Das im industriellen Einsatz hierzu verwendete Spektrum unterschiedlicher Signalformen reicht von leitungsgebunden übertragbaren analogen oder digitalen Signalen bis hin zu drahtlos übertragbaren hochfrequenten Signalen.

Zu den analogen Signalformen zählen z.B. in der Industrie häufig als 4-20 mA Signale bezeichnete Signale. Bei dieser Übertragungsform wird ein über die Übertragungsleitung, z.B. eine 2-Draht-Leitung, fließender Signalstrom in Abhängigkeit von einer vom Feldgerät bestimmten Größe, z.B. einer Messgröße, auf Werte zwischen 4 mA und 20 mA geregelt wird.

Zu den digitalen Signalformen zählen z.B. über Busleitungen übertragbare digitale Signale, wie sie in Busleitungssystemen, wie z.B. HART, Profibus PA, Profibus DP, Modbus oder Ethernet, zur uni- oder bidirektionalen digitalen Kommunikation verwendet werden.

Darüber hinaus werden in zunehmendem Maße auch hochfrequente Signale eingesetzt, wie sie beispielsweise zur drahtlosen Kommunikation über digitale Funk- oder Mobilfunknetze verwendet werden. Für diese Netze haben sich unterschiedliche Übertragungsstandards, wie z.B. Standards für das Global System for Mobile Communication (GSM), Bluetooth, WiFi oder Near Field Communication (NFC) etabliert. In dem Fall ist die an das Feldgerät anzuschließende Übertragungsleitung eine Koaxialleitung einer Antenne, über die diese Signale drahtlos gesendet und/oder empfangen werden.

Sowohl zur leitungsgebundenen als auch zur drahtlosen Informationsübertragung ist jeweils ein Adapter erforderlich, über den die innerhalb des Gehäuses des Feldgeräts angeordnete Elektronik an eine außerhalb des Gehäuses befindliche Übertragungsleitung angeschlossen werden kann. Der Adapter muss mindestens eine Durchführung aufweisen, über die die Leiter der Übertragungsleitung durch eine Öffnung in einer Gehäusewand des Gehäuses des Feldgeräts hindurch geführt werden.

Dabei werden an in explosionsgefährdeten Bereichen einsetzbare Feldgeräte besondere Sicherheitsanforderungen gestellt. Diese haben das Ziel eine Funkenbildung im Feldgerät zu vermeiden, oder zu verhindern, dass ein im Inneren des Feldgeräts entstehender Funke Auswirkungen auf die Umgebung hat. Dieses Ziel ist auf verschiedene Arten, die in entsprechenden Europäischen Normen als Zündschutzklassen bezeichnet sind, erreichbar. Eine unter der Bezeichnung 'Druckfeste Kapselung' (Ex-d) geführte Schutzklasse sieht vor, dass die Geräte ein druckfestes Gehäuse aufweisen, das sicherstellt, dass eine im Inneren des Gehäuses entstehender Funke, der möglicherweise sogar eine Explosion im Inneren des Feldgeräts auslöst, keine Zündung eines außerhalb des Feldgerät befindlichen explosiven Mediums bewirken kann.

Zur Erzielung einer druckfesten Kapselung müssen auch durch die Gehäusewand dieser Geräte verlaufende Durchführungen entsprechend ausgebildet sein. Hierzu werden heute z.B. druckfeste Glas oder Keramik-Durchführungen eingesetzt. Diese umfassen regelmäßig einen metallischen Träger, der eine durchgehende Bohrung aufweist. In die Bohrung ist eine Füllung aus Glas bzw. Keramik eingesetzt, in der mindestens ein Leiter durch die Bohrung hindurch verläuft. Bei diesen Durchführungen ist die Füllung bei einer Explosion im Inneren des Gehäuses unmittelbar dem Explosionsdruck ausgesetzt. Entsprechend muss die Verbindung zwischen der äußeren Mantelfläche der Füllung und der Innenwand der Bohrung ausreichend stabil sein, um dem Explosionsdruck standhalten zu können. Die Herstellung dieser Durchführungen ist daher vergleichsweise aufwendig und teuer. Außerdem sind die Materialkombinationen von Füllung, Leiter und Träger, zwischen denen in ausreichendem Maße druckfeste Verbindungen erzeugt werden können, begrenzt. Darüber hinaus besteht bei diesen Durchführungen das Problem, dass die als Füllung verwendbaren Materialien in der Regel harte und/oder spröde Werkstoffe sind, die einen thermischen Ausdehnungskoeffizienten aufweisen, der sich deutlich von dem thermischen Ausdehnungskoeffizienten der die Füllung außenseitlich umschließenden metallischen Träger unterscheidet. Aufgrund der unterschiedlichen Ausdehnungskoeffizienten bilden sich in diesen Durchführungen von der Umgebungstemperatur abhängige thermomechanische Spannungen aus. Dabei besteht insb. bei starken Temperaturveränderungen oder extrem hohen oder niedrigen Umgebungstemperaturen die Gefahr, dass Spannungsrisse in der Füllung entstehen, die die Dichtheit und die Druckfestigkeit dieser Durchführungen beeinträchtigen können.

Die Schrift JP03257427B2 beschreibt eine Antenneninstallationsstruktur mit einem explosionssicheren Steckverbinder.

Es ist eine Aufgabe der Erfindung, einen insb. in explosionsgefährdeten Bereichen einsetzbaren, druckfesten Adapter für den Anschluss einer Übertragungsleitung an ein Feldgerät anzugeben, der die Nachteile des vorgenannten Standes der Technik überwindet.

Hierzu umfasst die Erfindung einen Adapter für einen Anschluss einer Übertragungsleitung an ein Feldgerät, mit
- einer in eine Öffnung in einer Gehäusewand eines Gehäuses des Feldgeräts einsetzbaren Hülse, die im eingesetzten Zustand einen zu einem Innenraum des Gehäuses hin offenen und nach außen durch eine Stirnwand der Hülse verschlossenen Innenraum aufweist,
- einem in die Hülse eingesetzten Einsatz, der ein in der Hülse angeordnetes Basiselement und einen durch eine Öffnung in der Stirnwand der Hülse aus der Hülse heraus ragenden Fortsatz umfasst und dessen Basiselement eine Grundfläche aufweist, die größer als eine Grundfläche der Öffnung in der Stirnwand der Hülse ist,
- einem an einem aus der Hülse herausragenden Ende des Fortsatzes vorgesehenen Anschlusselement, an das die Übertragungsleitung anschließbar ist,
- mindestens einem durch eine Bohrung im Fortsatz hindurch an einen Anschluss des Anschlusselements angeschlossenen Leiter, der durch eine an die Bohrung anschließende zum Innenraum des Gehäuses hin offene Ausnehmung im Basiselement verläuft, und
- einem Verguss, der einen in der Hülse verbleibenden Hohlraum ausfüllt.

Eine Ausgestaltung umfasst einen erfindungsgemäßen Adapter, bei dem
- die Hülse aus einem druckfesten Material, insb. aus einem Metall, insb. aus Aluminium, Feinguss oder Edelstahl, besteht, und über eine druckfeste mechanische Verbindung, insb. eine Schraubverbindung oder eine Schweißung, mit der Gehäusewand des Feldgeräts verbindbar ist, und/oder
- der Verguss aus einem Epoxid-Harz oder aus Silikon besteht.

Eine erste Weiterbildung umfasst einen erfindungsgemäßen Adapter, bei dem
- eine in den Adapter, insb. in den Einsatz, eingesetzte Leiterplatte vorgesehen ist,
- die Leiterplatte mit Leiterbahnen ausgestattet ist, und
- jeder der Leiter über eine der Leiterbahnen mit einem zugehörigen Anschluss verbunden ist, über den der jeweilige Leiter an eine Elektronik des Feldgeräts anschließbar ist.

Gemäß einer bevorzugten Ausgestaltung der ersten Weiterbildung verlaufen die Leiterbahnen in der Leiterplatte.

Eine weitere Ausgestaltung der ersten Weiterbildung umfasst einen Adapter, bei dem
- die Leiterplatte im Adapter derart angeordnet ist, dass sie parallel zur Längsachse der Hülse durch den Adapter verläuft, wobei eine Flächennormale auf die Leiterplattenfläche senkrecht zur Längsachse der Hülse verläuft, und/oder
- die Leiterplatte einen in das Basiselement eingesetzten ersten Abschnitt und einen daran anschließenden durch die Hülse hindurch führenden zweiten Abschnitt umfasst.

Eine Weiterbildung der letztgenannten Ausgestaltung umfasst einen Adapter, bei dem die Leiterplatte zwei auf einander gegenüberliegenden Außenseiten des Basiselements verlaufende, insb. stegförmige, Leiterplattensegmente umfasst, die mit dem zweiten Abschnitt der Leiterplatte verbunden sind und die jeweils durch einen durch die Leiterplatte verlaufenden, ein Wandsegment des Basiselements aufnehmenden Schlitz von dem in das Basiselement eingesetzten ersten Abschnitt getrennt sind.

Gemäß einer Weiterbildung der ersten Weiterbildung ist eine Befestigungsvorrichtung vorgesehen, durch die das Basiselement und die darin eingesetzte Leiterplatte in der Hülse fixiert sind, insb. eine Befestigungsvorrichtung, die zu auf beiden Seiten der Leiterplatte senkrecht zur Längsachse des Adapters vorstehende Leiterplattenvorsprünge und einen in eine Nut in der Hülse eingespannten Klemmring umfasst, wobei der Klemmring auf der von der Stirnwand der Hülse abgewandten Seite der Leiterplattenvorsprünge angeordnet ist.

Eine erste Variante umfasst einen erfindungsgemäßen Adapter, bei dem
- die Übertragungsleitung eine mindestens einen Leiter umfassende Leitung, insb. eine zwei Leiter umfassende 2-Draht-Leitung oder eine mehradrige Busleitung, ist, und
- für jeden Leiter der Übertragungsleitung eine durch die Bohrung im Fortsatz hindurch an einen der Anschlüsse des Anschlusselements des Adapters angeschlossener Leiter, der durch die an die Bohrung im Fortsatz anschließende Ausnehmung im Basiselement verläuft.

Eine zweite Variante umfasst einen erfindungsgemäßen Adapter, bei dem
- die Übertragungsleitung eine einen Innenleiter und einen Außenleiter umfassende Koaxialleitung, insb. eine Koaxialleitung einer an das Feldgerät anschließbaren Antenne ist,
- die Anschlüsse des Anschlusselements einen Anschluss für den Innenleiter und einen Anschluss für den Außenleiter umfassen,
- der Anschluss für den Innenleiter durch die Bohrung im Fortsatz hindurch an den durch die Ausnehmung im Basiselemente verlaufenden Leiter angeschlossen ist,
- der Einsatz aus einem elektrisch leitfähigen Material, insb. aus Messing oder Aluminium, besteht,
- der Einsatz einen mit dem Anschluss für den Außenleiter verbundenen Außenleiter bildet, und
- der Einsatz gegenüber dem Leiter und der Hülse elektrisch isoliert ist.

Eine Weiterbildung des erfindungsgemäßen Adapters gemäß der ersten Weiterbildung und der zweiten Variante umfasst einen Adapter, bei dem
- das mit dem Anschluss für den Außenleiter verbundene Basiselement über eine in der Leiterplatte verlaufende Leiterbahn mit einem zugehörigen Anschluss verbunden ist, und
- die Leiterbahn, die den mit dem Anschluss für den Innenleiter verbundenen Leiter mit dem zugehörigen Anschluss verbindet, in der Leiterplatte verläuft.

Eine Ausgestaltung der letztgenannten Weiterbildung umfasst einen Adapter, bei dem das Basiselement über eine Verbindungsleitung, insb. eine auf einer Außenseite des Basiselements verlaufende Verbindungsleitung, mit der zugehörigen Leiterbahn der Leiterplatte verbunden ist.

Eine zweite Weiterbildung umfasst einen Adapter, bei dem Einsatz und Hülse elektrisch gegeneinander isoliert sind.

Eine Weiterbildung der letztgenannten Weiterbildung umfasst einen Adapter, bei dem
- das Basiselement außenseitlich von einem mit dem Verguss gefüllten Spalt umgeben ist, und
- zwischen der Hülse und dem Einsatz ein Isolator vorgesehen, der die Stirnwand der Hülse gegenüber der Stirnwand des Basiselements isoliert und den durch die Öffnung in der Stirnwand in der Hülse verlaufenden Fortsatz gegenüber der die Öffnung umgebenden Stirnwand isoliert,
   -- insb. ein Isolator, der einen zwischen der Stirnwand der Hülse und der Stirnwand des Basiselements angeordneten ringscheibenförmigen ersten Isolator-Bereich und und einen daran anschließenden den Fortsatz außenseitlich allseitig umschließenden zweiten Isolator-Bereich umfasst,
   -- insb. ein Isolator aus einem druckfesten Material oder ein Isolator dessen ersten Isolator-Bereich aus einem druckfesten Material besteht, insb. aus Keramik, einem druckfesten Kunststoff oder einem Leiterplattenbasismaterial, insb. mit Expoxidharz getränkten Glasfasermatten.

Gemäß einer weiteren Weiterbildung ist die mit dem Verguss gefüllte Hülse als Flammendurchschlagsperre ausgebildet.

Weiter umfasst die Erfindung ein Feldgerät mit einem erfindungsgemäßen Adapter und einer über den Adapter an eine Übertragungsleitung anschließbaren Elektronik.

Erfindungsgemäße Adapter bieten des Vorteil, dass die Druckfestigkeit gegenüber einem im Inneren des Feldgerät möglicherweise auftretenden Explosionsdrucks durch die Abstützung des Basiselements des Einsatzes auf der Stirnwand der Hülse bewirkt wird. Im Unterschied zu den eingangs erwähnten druckfesten Glas- oder Keramik Durchführungen ist bei erfindungsgemäßen Adaptern daher keine druckfeste Verbindung zwischen dem Verguss und den den Verguss Komponenten des Adapters erforderlich.

Das bietet den Vorteil, dass der Verguss aus einem im Vergleich zu Glas oder Keramik deutlich elastischeren Material bestehen kann, dass in der Lage ist durch unterschiedliche thermische Ausdehnungskoeffizienten der Komponenten des Adapters entstehende thermomechanische Spannungen aufzunehmen. Hierdurch werden Spannungsrisse im Verguss vermieden, so das erfindungsgemäße Adapter in einem größeren Temperaturbereich eingesetzt werden können, als herkömmliche Durchführungen. Dabei kann die mit dem Verguss gefüllte Hülse als über einen entsprechend großen Temperaturbereich zuverlässige Flammendurchschlagsperre ausgebildet werden.

Ein weiterer Vorteil besteht darin, dass erfindungsgemäße Adapter aufgrund der einfach aufgebauten Komponenten, für deren Zusammenbau keine speziellen Fügeverfahren benötigt werden, auf einfache und kostengünstige Weise hergestellt werden kann.

Die Erfindung und weitere Vorteile werden nun anhand der Figuren der Zeichnung, in denen drei Ausführungsbeispiele dargestellt sind, näher erläutert; gleiche Teile sind in den Figuren mit gleichen Bezugszeichen versehen.
- Fig. 1 zeigt:: einen in eine Gehäusewand eines Feldgeräts eingesetzten Adapter für eine 2-Draht-Leitung;
- Fig. 2 zeigt:: einen in eine Gehäusewand eines Feldgeräts eingesetzten Adapter für eine Busleitung; und
- Fig. 3 zeigt:: einen in eine Gehäusewand eines Feldgeräts eingesetzten Adapter für eine Koaxialleitung einer Antenne.

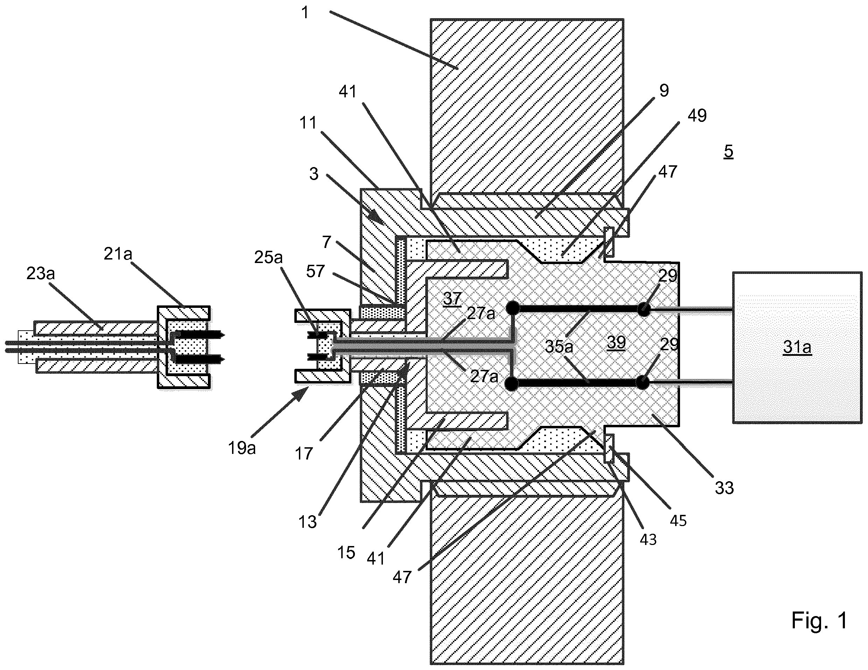

Fig. 1 zeigt eine Schnittzeichnung eines ersten Ausführungsbeispiels eines erfindungsgemäßen Adapters für ein Feldgerät. Der Adapter umfasst eine in eine Öffnung in einer Gehäusewand 1 eines Gehäuses einsetzbare Hülse 3, die im montierten Zustand eine zu einem Innenraum 5 des Gehäuses hin offenen und nach außen durch eine Stirnwand 7 der Hülse 3 verschlossenen Innenraum aufweist. Gehäuse und Hülse 3 bestehen aus einem druckfesten Material, z.B. aus einem Metall, z.B. aus Aluminium, Feinguss oder Edelstahl, und werden über eine druckfeste mechanische Verbindung, insb. eine Schraubverbindung oder eine Schweißung, miteinander verbunden. Bei der hier dargestellten Schraubverbindung weist die Hülse 3 vorzugsweise einen hohlzylindrischen, mit einem Außengewinde versehenen Schraubenstift 9 und einen die Stirnwand 7 umfassenden Schraubenkopf 11, z.B. einen Sechskantkopf, auf. In dem Fall ist die Öffnung in der Gehäusewand 1 mit einem Innengewinde ausgestattet, in das der Schraubenstift 9 eingeschraubt wird. Dabei weisen die Gewinde vorzugsweise eine zur Erzielung einer in hohem Maße druckfesten mechanischen Verbindung, insb. einer Verbindung mit einer Druckfestigkeit gegenüber Drücken von bis zu 80 bar, ausreichend große Gewindelänge auf. Entsprechende Mindestgewindelängen können beispielsweise europäischen oder internationalen Normen zur Zündschutzklasse der Druckfesten Kapselung entnommen werden. Der Schraubenkopf 11 kann - wie hier dargestellt - auf der die Öffnung umgebenden Außenseite der Gehäusewand 1 aufliegen, oder aber alternativ in der Gehäusewand 1 versenkt angeordnet werden.

Zusätzlich umfasst der Adapter 3 einen in die Hülse 3 eingesetzten Einsatz 13. Der Einsatz 13 umfasst ein im Innenraum der Hülse 3 angeordnetes Basiselement 15 und einen an das Basiselement 15 anschließenden, durch eine Öffnung in der Stirnwand 7 der Hülse 3 herausragenden Fortsatz 17. Das Basiselement 15 weist eine Grundfläche auf, die größer als eine Grundfläche der Öffnung in der Stirnwand ist. Hierdurch wird bewirkt, dass die Stirnwand 7 der Hülse 3 ein stabiles Gegenlager für den Einsatz 13 bildet, das einem bei einer Explosion im Inneren des Gehäuses entstehenden auf den Einsatz 13 wirkenden Explosionsdruck ohne weiteres standhält.

An dem aus der Öffnung in der Stirnwand 7 der Hülse 3 herausragenden Ende des Fortsatzes 17 ist ein - hier nur schematisch dargestelltes - Anschlusselement 19a vorgesehen, an das eine mit einem hierzu komplementären, ebenfalls nur schematisch dargestellten Anschlusselement 21a ausgestattete Übertragungsleitung 23a anschließbar ist.

Zusätzlich umfasst der Adapter mindestens einen durch eine Bohrung im Fortsatz 17 hindurch an einen zugehörigen Anschluss 25a des Anschlusselements 19a des Adapters angeschlossenen Leiter 27a, der durch eine an die Bohrung anschließende zum Innenraum des Gehäuses 5 hin offene Ausnehmung im Basiselement 13 verläuft.

In dem in Fig. 1 dargestellten Ausführungsbeispiel ist die Übertragungsleitung 23a eine 2-Draht-Leitung. Entsprechend umfasst der Adapter hier zwei durch den Einsatz 13 verlaufende Leiter 27a, die über die beiden Anschlusselemente 19a, 21a an die beiden Leiter der Übertragungsleitung 23a angeschlossen werden können.

Zusätzlich umfasst der Adapter Anschlüsse 29, über die die vom Anschlusselement 19a des Adapters abgewandten Enden der Leiter 27a an eine im Inneren des Gehäuses des Feldgeräts angeordnete Elektronik 31a anschließbar sind. Die Anschlüsse 29 sind im dargetellten Ausführungsbeispiel Anschlusskontakte, an die eine entsprechende Leitung z.B. durch eine Lötung angeschlossen werden kann. Alternativ können die Anschlüsse 29 als Stecker oder Steckverbinder ausgebildet sein. In dem dargestellten Ausführungsbeispiel umfasst die Elektronik 31a z.B. eine Schaltung, die einen über die 2-Drahtleitung fließenden Strom derart einstellt, dass dieser einer vom Feldgerät gemessenen physikalischen Messgröße entspricht. Zusätzlich kann bei entsprechender Ausgestaltung der Elektronik 31a auch die Energieversorgung des Feldgeräts über die 2-Drahtleitung erfolgen. Entsprechende Schaltungen sind aus dem Stand der Technik bekannt, und daher hier nicht im Detail beschrieben.

Grundsätzlich wäre es möglich, die Leiter 27a in einem Kabelmantel durch die Hülse 3 hindurch zu führen und unmittelbar an die Elektronik 31a anzuschließen. Ein solches Vorgehen ist jedoch in vielen Ländern aufgrund von Explosionsschutzvorschriften für in explosionsgefährdeten Bereichen einsetzbare Feldgeräten nicht zulässig, da Kabelmäntel regelmäßig aus fließfähigen, für den Einsatz in explosionsgefährdeten Bereichen ungeeigneten Kunststoffen bestehen und ein zwischen Leiter 27a und Kabelmantel bestehender, bis in den Innenraum 5 des Gehäuses führender Spalt ein Sicherheitsrisiko dargestellt.

Der Anschluss der Leiter 27a an die Elektronik 31 a erfolgt daher vorzugsweise über eine in den Adapter eingesetzte Leiterplatte 33. Die Leiterplatte 33 ist mit einer Anzahl der Leiter 27a entsprechenden Anzahl von Leiterbahnen 35a ausgestattet, über die der jeweilige Leiter 27a mit dem zugehörigen Anschluss 29 verbunden ist. Die Leiterbahnen 35a können - wie in Fig. 1 dargestellt - auf der Leiterplatte 33 verlaufen, oder alternativ auch als in der Leiterplatte 33 verlaufende Leiterbahnen ausgebildet sein.

Die Leiterplatte 33 ist im Adapter vorzugsweise derart angeordnet, dass sie parallel zur Längsachse der Hülse 3 durch den Adapter verläuft, wobei eine Flächennormale auf die Leiterplattenfläche senkrecht zur Längsachse der Hülse 3 verläuft.

Die Leiterplatte 33 umfasst einen in das Basiselement 15 eingesetzten ersten Abschnitt 37 und einen daran anschließenden durch die Hülse 3 hindurch führenden zweiten Abschnitt 39. Vorzugsweise umfasst die Leiterplatte 33 zusätzlich zwei auf einander gegenüberliegenden Außenseiten des Basiselements 15 verlaufende, vorzugsweise stegförmige Leiterpfattensegmente 41, die mit dem zweiten Abschnitt 39 der Leiterplatte 33 verbunden sind. Diese Leiterplattensegmente 41 sind jeweils durch einen durch die Leiterplatte 33 verlaufenden Schlitz von dem in das Basiselement 15 eingesetzten ersten Abschnitt 37 getrennt. Das bietet den Vorteil, dass die Leiterplatte 33 auf das Basiselement 15 aufgesteckt werden kann, wobei die Schlitze jeweils ein Wandsegment des Basiselements 15 aufnehmen.

Zusätzlich umfasst der Adapter eine Befestigungsvorrichtung, durch die das Basiselement 15 und die darin eingesetzte Leiterplatte 33 in der Hülse 3 fixiert sind. Hierzu eignet sich z.B. ein in eine Nut 43 im Schraubenstift 9 eingespannter Klemmring 45, der ein Gegenlager zu auf beiden Seiten der Leiterplatte 33 senkrecht zur Längsachse des Adapters 3 vorstehenden Leiterplattenvorsprüngen 47 bildet. Dabei ist der Klemmring 45 auf der von der Stirnwand 7 der Hülse 3 abgewandten Seite der Leiterplattenvorsprünge 47 angeordnet, so dass er einer Bewegung des Verbunds aus dem Einsatz 13 und der in den Einsatz 13 eingesetzten Leiterplatte 33 in von der Stirnwand 7 abgewandter Richtung entgegenwirkt.

Bei erfindungsgemäßen Adaptern ist ein im Innenraum der Hülse 3 verbleibender Hohlraum mit einem Verguss 49 gefüllt. Der Verguss 49 füllt auch einen nach dem Einsetzen der Leiterplatte 33 im Basiselement 15 verbleibenden Hohlraum im Basiselement 15. Darüber hinaus ist vorzugsweise auch ein im Fortsatz 17 verbleibenden Hohlraum mit dem Verguss 49 oder alternativ mit einem darin eingesetzten Isolator ausgefüllt.

Die mit Verguss 49 gefüllte Hülse 3 ist vorzugsweise als Flammendurchschlagsperre ausgebildet, die verhindert, dass ein im Feldgerät entstehender Funke eine Zündung eines außerhalb des Feldgeräts befindlichen explosiven Mediums bewirken kann. Anforderungen an als Flammendurchschlagsperre einsetzbare mit einem Verguss gefüllte Hohlräume sind in vielen Ländern durch entsprechende Explosionsschutz-Normen regelt, die hier zur entsprechenden Ausgestaltung von Hülse 3 und Verguss 49 herangezogen werden können. Eine z.B. gemäß der Deutschen Industrienorm DIN-EN 60079-1 aus dem Jahr 2007 in Verbindung mit der Schutzklasse der Druckfesten Kapselung (Ex-d) zulässige Ausgestaltung besteht darin, ist die Hülse 3 derart zu bemessen, dass die kürzeste im Verguss 49 durch den Adapter hindurch verlaufende Wegstrecke bei einem Gesamtvolumen des Vergusses 49 von weniger als 10 cm³ mindestens 3 mm, bei einem Gesamtvolumen des Vergusses 49 von mehr als 10 cm³ und weniger 100 cm³ als mindestens 6 mm, sowie bei einem Gesamtvolumen des Vergusses 49 von mehr als 100 cm³ mindestens 10 mm beträgt.

Durch die Kombination der druckfesten Abstützung des Basiselements 15 des Einsatzes 13 auf der Stirnwand der Hülse 3 und die durch den mit Verguss 49 gefüllte Hülse 3 bewirkte Flammendurchschlagsperre ist es möglich, den Adapter in explosionsgefährdeten Bereichen einzusetzen.

Im Unterschied zu den eingangs erwähnten druckfesten Glas- oder Keramik Durchführungen ist bei erfindungsgemäßen Adaptern keine druckfeste Verbindung zwischen dem Verguss 49 und den den Verguss 49 umgebenden Komponenten des Adapters erforderlich. Stattdessen wird der Explosionsdruck einer im Inneren des Feldgeräts auftretenden Explosion bei den erfindungsgemäßen Adaptern durch die Abstützung des Basiselements 15 auf der Stirnwand 7 der Hülse 3 aufgefangen.

Das bietet den Vorteil, dass der Verguss 49 aus einem im Vergleich zu Glas oder Keramik deutlich elastischeren Material, z.B. aus einem Harz, z.B. einem Epoxid-Harz, oder aus Silikon, bestehen kann. Elastischere Verguss-Materialen bieten den Vorteil, dass sie durch unterschiedliche thermische Ausdehnungskoeffizienten der Komponenten des Adapters entstehende thermomechanische Spannungen aufnehmen können. Hierdurch werden Spannungsrisse im Verguss 49 auch dann vermieden, wenn der Adapter großen Temperaturschwankungen und/oder sehr hohen oder sehr niedrigen Temperaturen ausgesetzt wird.

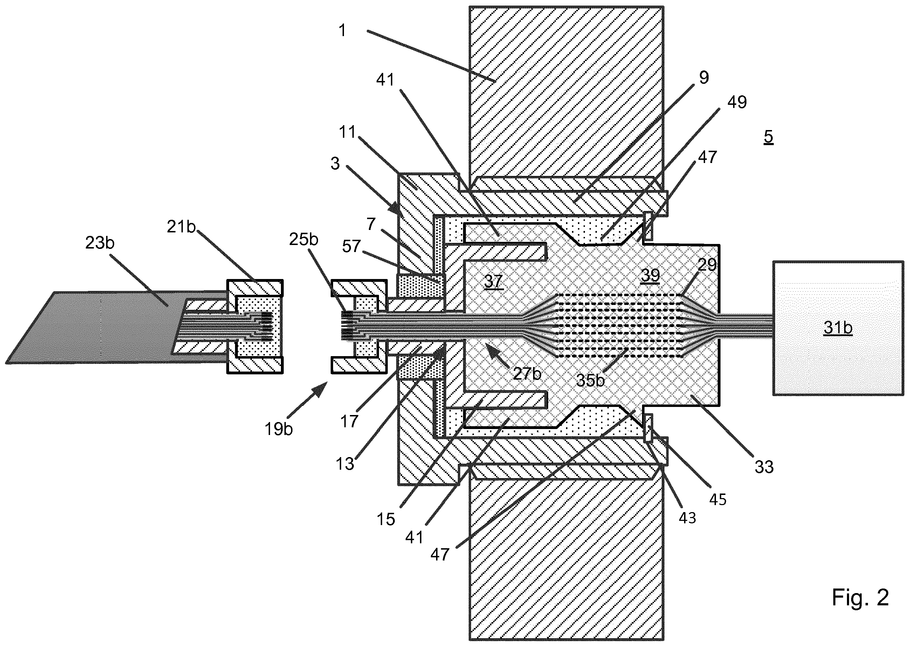

Fig. 2 zeigt ein zweites Ausführungsbeispiel eines erfindungsgemäßen Adapters. Dieser unterscheidet sich von dem in Fig. 1 dargestellten Ausführungsbeispiel dadurch, dass dieser Adapter für den Anschluss einer - hier als Busleitung ausgebildeten - mehr-adrigen Übertragungsleitung 23b ausgelegt ist. Entsprechend sind Adapter und Übertragungsleitung 23b hier mit für den Anschluss einer Busleitung geeigneten Anschlusselementen 19b, 21 b, wie z.B. aus dem Stand der Technik bekannten, je nach Busleitungssystem in der Regel 9-poligen oder 12-poligen Steckverbindern, ausgestattet sind. Dabei ist für jede Ader der Busleitung ein an den entsprechenden Anschluss 25b des Anschlusselements 19b des Adapters angeschlossener, durch den Fortsatz 17 in den Adapter hinein geführter Leiter 27b vorgesehen. Die Leiter 27b sind auch hier vorzugsweise jeweils an eine zughörige Leiterbahn 35b der Leiterplatte 33 angeschlossen, über deren Anschluss 29, z.B. einen Anschlusskontakt, einen Stecker oder Steckverbinder, sie dann an die Elektronik 31b des Feldgeräts angeschlossen werden kann. Die Elektronik 31b umfasst in diesem Fall ein Datenübertragungsmodul, dass die digitale Kommunikation über die Busleitung übernimmt. Da die digitale Kommunikation über Busleitungen regelmäßig über höherfrequente Signale erfolgt, verlaufend die Leiterbahnen 35b hier vorzugsweise innerhalb der Leiterplatte 33. Hierdurch werden Wechselwirkung der höherfrequenten Signale mit dem Verguss 49 vermieden.

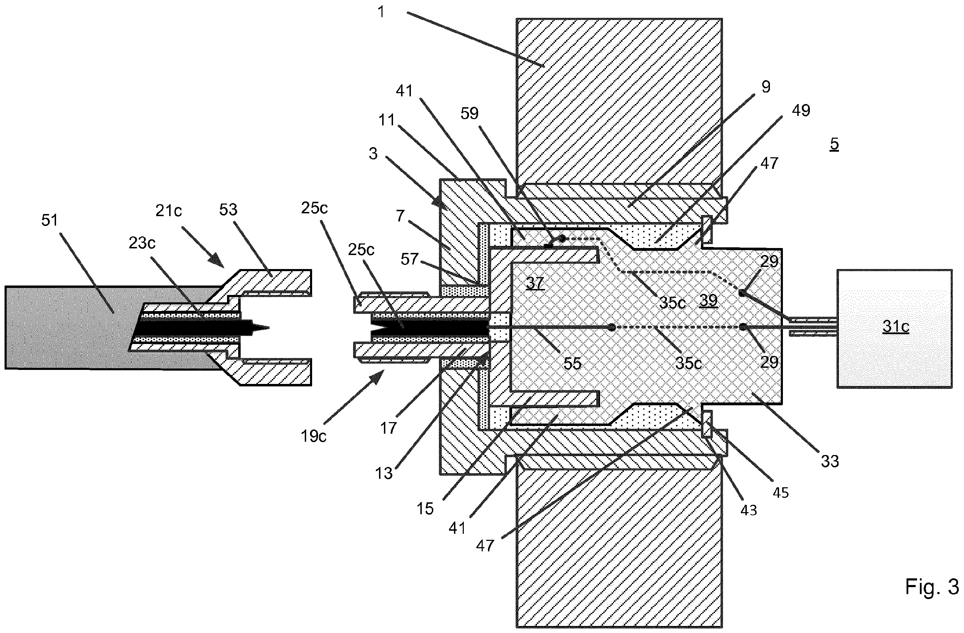

Fig. 3 zeigt ein weiteres Ausführungsbeispiel eines erfindungsgemäßen Adapters. Dieser unterscheidet sich von den vorherigen Ausführungsbeispielen dadurch, dass er für den Anschluss einer hier als Koaxialleitung ausgebildeten Übertragungsleitung 23c ausgebildet ist. Die Übertragungsleitung 23c ist z.B. eine Koaxialleitung einer Antenne 51, über die hochfrequente Signale drahtlos gesendet und/oder empfangen werden. Entsprechend sind Adapter und Übertragungsleitung 23c hier mit für den Anschluss einer Koaxialleitung geeigneten Anschlusselementen 19c, 21c, wie z.B. aus dem Stand der Technik bekannte SMA-Steckverbinder oder F-Steckverbinder, ausgestattet, über die die Antenne 51, vorzugsweise mittels einer am Anschlusselemente 21c der Antenne 51 vorgesehenen Überwurfmutter 53, auf dem Adapter mechanisch befestigt und elektrisch angeschlossen werden kann.

Auch bei dieser Variante wäre es grundsätzlich möglich Innen- und Außenleiter der anzuschließenden Koaxialleitung durch die Bohrung im Fortsatz 17 hindurch in den Adapter hinein zu führen.

Vorzugsweise wird hier jedoch ein anderer Weg eingeschlagen. Dabei wird der Einsatz 13 als Außenleiter verwendet, so dass nur der Innenleiter der Koaxialleitung durch die Bohrung im Fortsatz 17 geführt werden muss. Hierzu besteht der Einsatz 13 aus einem elektrisch leitfähigen Material, z.B. aus Messing oder Aluminium, und es ist nur ein durch die Bohrung im Fortsatz 17 hindurch mit dem für den Innenleiter der Koaxialleitung vorgesehenen Anschluss 25c des Anschlusselements 19c verbundener Leiter 55 vorgesehen, der gegenüber dem Einsatz 13 elektrisch isoliert ist und durch die an die Bohrung anschließende Ausnehmung im Basiselement 15 verläuft. Zur Isolation des Leiters 55 gegenüber dem Fortsatz 17 ist in dem zwischen dem durch den Fortsatz 17 verlaufenden Teil des Leiters 55 und dem Fortsatz 17 befindlichen hohlzylindrischen Spalt z.B. ein Abstandshalter oder eine Füllung aus einem Dielektrikum vorgesehen. Bei dieser Variante bildet der im Wesentlichen hohlzylindrische Fortsatz 17 vorzugsweise zugleich den Anschluss 25c des Anschlusselements 19c für den Außenleiter.

Diese Variante kann extrem kostengünstig hergestellt werden, indem ein handelsübliches Anschlusselement für den Anschluss von Koaxialleitungen, wie z.B. ein SMA- oder F-Steckverbinder auf dem Basiselement 15 montiert, z.B. aufgelötet wird, dessen Außenleiter den Fortsatz 17 bildet und dessen Innenleiter den durch die Bohrung im Fortsatz 17 verlaufenden Teil des Leiters 55 bildet, an den dann der durch die Ausnehmung im Basiselement 13 verlaufende Teil des Leiters 55 angeschlossenen wird.

Einsatz 13 und Hülse 3 sind vorzugsweise elektrische gegeneinander isoliert. Bei dem hier dargestellten Ausführungsbeispiel ist das Basiselement 15 außenseitlich durch den das Basiselement 15 außenseitlich umgebenden, vergossenen hohlzylindrischen Spalt zwischen Basiselement 15 und Hülse 3 gegenüber der Hülse 3 isoliert. Zusätzlich ist zwischen der Hülse 3 und dem Einsatz 13 ein Isolator 57 vorgesehen, der eine Isolation zwischen der Stirnwand 7 der Hülse 3 und der Stirnwand des Basiselements 13, sowie zwischen dem durch die Öffnung in der Stirnwand 7 in der Hülse 3 verlaufenden Fortsatz 17 und der die Öffnung umgebenden Stirnwand 7 bewirkt. Der Isolator 57 umfasst z.B. einen zwischen der Stirnwand 7 der Hülse 3 und der Stirnwand des Basiselements 13 angeordneten ringscheibenförmigen ersten Isolator-Bereich und einen daran anschließenden den Fortsatz 17 außenseitlich allseitig umschließenden zweiten Isolator-Bereich. Der zweite Isolator-Bereich ist vorzugsweise derart ausgebildet, dass er einen zwischen dem Fortsatz 17 und der Öffnung in der Stirnwand 7 bestehenden Spalt vollständig ausfüllt.
Dabei besteht der zwischen der Stirnwand 7 der Hülse 3 und der Stirnwand des Basiselements 13 angeordnete erste Isolator-Bereich vorzugsweise aus einem druckfesten Material, z.B. aus Keramik. Alternativ hierzu kann er auch aus einem druckfesten, isolierenden Kunststoff oder einen druckfesten, isolierenden Leiterplattenbasismaterial, z.B. aus unter der Bezeichnung FR4 bekannten mit Expoxidharz getränkten Glasfasermatten, bestehen. Ist der Isolator 57 einteilig ausgebildet, so besteht er vorzugsweise insgesamt aus diesem Material. Ist der Isolator 57 zweiteilig ausgebildet, so kann der zweite Isolator-Bereich aus einem anderen Material, z.B. aus einem isolierenden Verguss, bestehen.
Eine Isolation zwischen Einsatz 13 und Hülse 3 ist vorzugsweise auch bei den in den Figuren 1 und 2 dargestellten Ausführungsbeispielen vorgesehen. Auch dort kann sie, wie in Fig. 1 und 2 dargestellt, durch den vergossenen hohlzylindrischen Spalt zwischen Basiselement 15 und Hülse 3 und den zwischen der Hülse 3 und dem Einsatz 13 vorgesehenen Isolator 57 realisiert werden.

Die Isolation bietet den Vorteil, dass sie eine Potentialtrennung zwischen dem Potential des Einsatzes 13 und dem Potential der im Einsatz mit der Gehäusewand 1 verbundenen und damit auf dem Potential des - in der Regel geerdeten Gehäuses - liegenden Hülse 3 bewirkt.

Bei dem in Fig. 3 dargestellten Ausführungsbeispiel ist die Leiterplatte 33 mit zwei Leiterbahnen 35c ausgestattet, über die der den Innenleiter fortsetzende Leiter 55 und das den Außenleiter fortsetzende Basiselement 15 mit dem jeweils zugehörigen, auf dem vom Basiselement 13 abgewandten Abschnitt 39 der Leiterplatte 33 vorgesehenen Anschluss 29 verbunden sind. Hierzu ist der Leiter 55 unmittelbar mit der zugehörigen Leiterbahn 35c der Leiterplatte 33 verbunden, und das Basiselement 15 ist über eine Verbindungsleitung 59 an die zugehörige Leiterbahn 35c der Leiterplatte 33 angeschlossen. Die Verbindungsleitung 59 verläuft vorzugsweise auf der Außenseite des Basiselements 15 und ist beispielsweise auf einem der beiden außenseitlich unmittelbar an das Basiselement 13 angrenzenden stegförmigen Leiterplattensegmente 41 an die zugehörige Leiterbahn 35c angeschlossen.

Die Leiterbahnen 35c verlaufen auch hier vorzugsweise innerhalb der Leiterplatte 33. Hierdurch werden Wechselwirkungen der zu übertragenden Signale mit dem Verguss 49 vermieden.

Entsprechend können mit dem erfindungsgemäßen Adapter ohne Weiteres Signale übertragen werden, die Frequenzen aufweisen, wie sie in Verbindung mit den eingangs genannten Übertragungsstandards, Global System for Mobile Communication (GSM), Bluetooth, WiFi, oder Near Field Communication (NFC) verwendet werden. Diese Übertragungsstandards verwenden je nach Standard Frequenzbereiche im Bereich von einigen Hundert Mega-Herz- Bereich bis zu Frequenzbereichen im Bereich einem oder zwei Giga-Herz. Dabei ist die Datenübertragungsrate in der Regel umso höher, je höher die zur Übertragung verwendeten Frequenzen sind.

Durch geeignete Wahl der Werkstoffe von Leiterplatte 33 und Einsatz 13 und eine frequenzangepasste Dimensionierung des Einsatzes 13 können sogar noch höhere Frequenzen aufweisende Signale übertragen werden. So können beispielsweise mit einer Leiterplatte 33 aus Keramik und einem entsprechend dimensionierten Einsatz 13 aus Messing Signale mit Frequenzen von 5 GHz und mehr übertragen werden, über die entsprechend höhere Datenübertragungsraten erzielt werden können.

Die - auch hier z.B. als Anschlusskontakt, Stecker oder Steckverbinder ausgebildeten - Anschlüsse 29 sind im Feldgerät über eine Koaxialleitung an die im Feldgerät integrierte Elektronik 31c angeschlossen, die in diesem Fall ein entsprechend dem gewählten Übertragungsstandard ausgebildetes Hochfrequenzmodul zum Senden und/oder Empfangen der über die Übertragungsleitung 23c bzw. die Antenne 51 zu übertragenden hochfrequenten Signale umfasst.
- 1: Gehäusewand
- 3: Hülse
- 5: Innenraum des Gehäuses
- 7: Stirnwand der Hülse
- 9: Schraubenstift
- 11: Schraubenkopf
- 13: Einsatz
- 15: Basiselement
- 17: Fortsatz
- 19: Anschlusselement
- 21: Anschlusselement
- 23: Übertragungsleitung
- 25: Anschlusskontakt
- 27: Leiter
- 29: Anschlüsse
- 31: Elektronik
- 33: Leiterplatte
- 35: Leitung
- 37: Abschnitt der Leiterplatte
- 39: Abschnitt der Leiterplatte
- 41: stegförmiges Leiterplattensegment
- 43: Nut
- 45: Klemmring
- 47: Leiterplattenvorsprung
- 49: Verguss
- 51: Antenne
- 53: Überwurfmutter
- 55: Leiter
- 57: Isolator
- 59: Verbindungsleitung

## Patentansprüche

1. Adapter für einen Anschluss einer Übertragungsleitung (23a, 23b, 23c) an ein Feldgerät, mit
- einer in eine Öffnung in einer Gehäusewand (1) eines Gehäuses des Feldgeräts einsetzbaren Hülse (3), die im eingesetzten Zustand einen zu einem Innenraum des Gehäuses hin offenen und nach außen durch eine Stirnwand (7) der Hülse (3) verschlossenen Innenraum aufweist und einen Verguss (49) aufweist, der einen in der Hülse (3) verbleibenden Hohlraum ausfüllt,
**dadurch gekennzeichnet, dass** der Adapter
- einen in die Hülse (3) eingesetzten Einsatz (13), der ein in der Hülse (3) angeordnetes Basiselement (15) und einen durch eine Öffnung in der Stirnwand (7) der Hülse (3) aus der Hülse (3) heraus ragenden Fortsatz (17) umfasst, und dessen Basiselement (15) eine Grundfläche aufweist, die größer als eine Grundfläche der Öffnung in der Stirnwand (7) der Hülse (3) ist,
- einen an einem aus der Hülse (3) herausragenden Ende des Fortsatzes (17) vorgesehenen Anschlusselement (19a, 19b, 19c) aufweist, an das die Übertragungsleitung (23a, 23b, 23c) anschließbar ist,
- mindestens einen durch eine Bohrung im Fortsatz (17) hindurch an einen Anschluss (25a, 25b, 25c) des Anschlusselements (19a, 19b, 19c) angeschlossenen Leiter (27a, 27b, 55) aufweist, der durch eine an die Bohrung im Fortsatz (17) anschließende zum Innenraum (5) des Gehäuses hin offene Ausnehmung im Basiselement (15) verläuft.

2. Adapter gemäß Anspruch 1, bei dem
- die Hülse (3) aus einem druckfesten Material-besteht, und über eine druckfeste mechanische Verbindung-mit der Gehäusewand (1) des Feldgeräts verbindbar ist, und/oder
- der Verguss (49) aus einem Epoxid-Harz oder aus Silikon besteht.

3. Adapter gemäß Anspruch 1, bei dem
- eine in den Adapter-eingesetzte Leiterplatte (33) vorgesehen ist,
- die Leiterplatte (33) mit Leiterbahnen (35a, 35b, 35c) ausgestattet ist, und
- jeder der Leiter (27a, 27b, 55) über eine der Leiterbahnen (35a, 35b, 35c) mit einem zugehörigen Anschluss (29) verbunden ist, über den der jeweilige Leiter (27a, 27b, 55) an eine Elektronik (31a, 31b, 31c) des Feldgeräts anschließbar ist.

4. Adapter gemäß Anspruch 3, bei dem die Leiterbahnen (35a, 35b, 35c) in der Leiterplatte (33) verlaufen.

5. Adapter gemäß Anspruch 3, bei dem
- die Leiterplatte (33) im Adapter derart angeordnet ist, dass sie parallel zur Längsachse der Hülse (3) durch den Adapter verläuft, wobei eine Flächennormale auf die Leiterplattenfläche senkrecht zur Längsachse der Hülse (3) verläuft, und/oder
- die Leiterplatte (33) einen in das Basiselement (15) eingesetzten ersten Abschnitt (37) und einen daran anschließenden durch die Hülse (3) hindurch führenden zweiten Abschnitt (39) umfasst.

6. Adapter gemäß Anspruch 4, bei dem die Leiterplatte (33) zwei auf einander gegenüberliegenden Außenseiten des Basiselements (15) verlaufende Leiterplattensegmente (41) umfasst, die mit dem zweiten Abschnitt (39) der Leiterplatte (33) verbunden sind und die jeweils durch einen durch die Leiterplatte (33) verlaufenden, ein Wandsegment des Basiselements (15) aufnehmenden Schlitz von dem in das Basiselement (15) eingesetzten ersten Abschnitt (37) getrennt sind.

7. Adapter gemäß Anspruch 3, bei dem eine Befestigungsvorrichtung vorgesehen ist, durch die das Basiselement (15) und die darin eingesetzte Leiterplatte (33) in der Hülse (3) fixiert sind-; die zu auf beiden Seiten der Leiterplatte (33) senkrecht zur Längsachse des Adapters (3) vorstehende Leiterpiattenvorsprünge (47) und einen in eine Nut (43) in der Hülse (3) eingespannten Klemmring (45) umfasst, wobei der Klemmring (45) auf der von der Stirnwand (7) der Hülse (3) abgewandten Seite der Leiterpiattenvorsprünge (47) angeordnet ist.

8. Adapter gemäß Anspruch 1, bei dem
- die Übertragungsleitung (21a, 21b) eine mindestens einen Leiter umfassende Leitung-ist, und
- für jeden Leiter der Übertragungsleitung (21a, 21b) ein durch die Bohrung im Fortsatz (17) hindurch an einen der Anschlüsse (25a, 25b) des Anschlusselements (19a, 19b) des Adapters angeschlossener Leiter (27a, 27b) vorgesehen ist, der durch die an die Bohrung im Fortsatz (17) anschließende Ausnehmung im Basiselement (15) verläuft.

9. Adapter gemäß Anspruch 1, bei dem
- die Übertragungsleitung (21c) eine einen Innenleiter und einen Außenleiter umfassende Koaxialleitung einer an das Feldgerät anschließbaren Antenne (51) ist,
- die Anschlüsse (25c) des Anschlusselements (19c) einen Anschluss (25c) für den Innenleiter und einen Anschluss (25c) für den Außenleiter umfassen,
- der Anschluss (25c) für den Innenleiter durch die Bohrung im Fortsatz (17) hindurch an den durch die Ausnehmung im Basiselement (15) verlaufenden Leiter (55) angeschlossen ist,
- der Einsatz (13) aus einem elektrisch leitfähigen Material-besteht,
- der Einsatz (13) einen mit dem Anschluss (25c) für den Außenleiter verbundenen Außenleiter bildet, und
- der Einsatz (13) gegenüber dem Leiter (55) und der Hülse (3) elektrisch isoliert ist.

10. Adapter gemäß Anspruch 3 und 9, bei dem
- das mit dem Anschluss (25c) für den Außenleiter verbundene Basiselement (15) über eine in der Leiterplatte (33) verlaufende Leiterbahn (35c) mit dem zugehörigen Anschluss (29) verbunden ist, und
- die Leiterbahn (35c), die den mit dem Anschluss (25c) für den Innenleiter verbundenen Leiter (55) mit dem zugehörigen Anschluss (29) verbindet, in der Leiterplatte (33) verläuft.

11. Adapter gemäß Anspruch 10, bei dem das Basiselement (15) über eine Verbindungsleitung (59) mit der zugehörigen Leiterbahn (35c) der Leiterplatte (33) verbunden ist.

12. Adapter gemäß Anspruch 1, bei dem Einsatz (13) und Hülse (3) elektrisch gegeneinander isoliert sind.

13. Adapter gemäß Anspruch 12, bei dem
- das Basiselement (15) außenseitlich von einem mit dem Verguss (49) gefüllten Spalt umgeben ist, und
- zwischen der Hülse (3) und dem Einsatz (13) ein Isolator (57) vorgesehen, der die Stirnwand (7) der Hülse (3) gegenüber der Stimwand des Basiselements (13) isoliert und den durch die Öffnung in der Stirnwand (7) in der Hülse (3) verlaufenden Fortsatz (17) gegenüber der die Öffnung umgebenden Stirnwand (7) isoliert.

14. Adapter gemäß Anspruch 1, bei dem die mit dem Verguss (49) gefüllte Hülse (3) als Flammendurchschlagsperre ausgebildet ist.

15. Feldgerät mit einem Adapter gemäß einem oder mehreren der vorangehenden Ansprüche und einer über den Adapter an eine Übertragungsleitung (23a, 23b, 23c) anschließbaren Elektronik (31a, 31b, 31c).

## Claims

1. Adapter for connecting a transmission cable (23a, 23b, 23c) to a field device, with
- a sleeve (3) that can be inserted in an opening in a housing wall (1) of a housing of the field device, wherein - when inserted - said sleeve has an interior area that is open in the direction of an interior area of the housing and sealed towards the outside by a front wall (7) of the sleeve (3), and wherein said sleeve has a potting (49) that fills a cavity remaining in the sleeve (3);
**characterized in that**
the adapter has
- and insert (13) inserted into the sleeve (3), said insert comprising a basic element (15) arranged in the sleeve (3) as well as an extension (17) projecting out of the sleeve (3) through an opening in the front wall (7) of the sleeve (3), and wherein said basic element (15) has a base area that is greater than a base area of the opening in the front wall (7) of the sleeve (3),
- a connection element (19a, 19b, 19c) provided on an end of the extension (17) projecting out of the sleeve (3), wherein the transmission cable (23a, 23b, 23c) can be connected to said connection element,
- at least one conductor (27a, 27b, 55) connected to a connection (25a, 25b, 25c) of the connection element (19a, 19b, 19c) through a bore in the extension (17), wherein said conductor extends through a recess in the basic element (15) that is open in the direction of the interior area (5) of the housing and is adjacent to the bore in the extension (17).

2. Adapter as claimed in Claim 1, wherein
- the sleeve (3) is made from a pressure-resistant material and can be connected to the housing wall (1) of the field device via a pressure-resistant mechanical connection, and/or
- the potting (49) consists of an epoxy resin or silicone.

3. Adapter as claimed in Claim 1, wherein
- a printed circuit board (33), which is inserted in the adapter, is provided
- the printed circuit board (33) is equipped with conductive tracks (35a, 35b, 35c), and
- each of the conductors (27a, 27b, 55) is connected to a corresponding connection (29) via one of the conductive tracks (35a, 35b, 35c), wherein said conductor (27a, 27b, 55) can be connected to an electronics unit (31a, 31b, 31c) of the field device via said corresponding connection.

4. Adapter as claimed in Claim 3, wherein the conductive tracks (35a, 35b, 35c) run in the printed circuit board (33).

5. Adapter as claimed in Claim 3, wherein
- the printed circuit board (33) is arranged in the adapter in such a way that it runs parallel to the longitudinal axis of the sleeve (3) through the adapter, wherein a surface normal on the surface of the printed circuit board is perpendicular to the longitudinal axis of the sleeve (3), and/or
- the printed circuit board (33) comprises a first part (37), which is inserted into the basic element (15), and a second part (39), which is adjacent to the first part and is guided through the sleeve (3).

6. Adapter as claimed in Claim 4, wherein the printed circuit board (33) comprises two printed circuit board segments (41) extending on the external sides of the basic element (15) that are opposite one another, wherein said segments are connected to the second part (39) of the printed circuit board (33) and are separated from the first part (37) inserted into the basic element (15) by means of a slot that runs through the printed circuit board (33) and occupies a wall segment of the basic element (15).

7. Adapter as claimed in Claim 3, wherein a securing mechanism is provided by means of which the basic element (15) and the printed circuit board (33) inserted in the basic element are fixed in the sleeve (3), said securing mechanism comprising printed circuit board projections (47) that protrude on both sides of the printed circuit board (33) and are perpendicular to the longitudinal axis of the adapter (3), and a clamping ring (45) that is clamped in a groove (43) in the sleeve (3), wherein the clamping ring (45) is arranged on the side of the printed circuit board projections (47) facing away from the front wall (7) of the sleeve (3).

8. Adapter as claimed in Claim 1, wherein
- the transmission cable (21a, 21b) is a cable comprising at least one conductor, and
- a conductor (27a, 27b), which is connected to one of the connections (25a, 25b) of the connection element (19a, 19b) of the adapter by means of the bore in the extension (17) and which runs through the recess in the basic element (15) that is adjacent to the bore in the extension, is provided for each conductor of the transmission cable (21a, 21b).

9. Adapter as claimed in Claim 1, wherein
- the transmission cable (21c) is a coaxial cable of an antenna (51) that can be connected to the field device, said coaxial cable comprising an inner conductor and an outer conductor,
- the connections (25c) of the connection element (19c) comprise a connection (25c) for the inner conductor and a connection (25c) for outer conductor,
- the connection (25c) for the inner conductor is connected to the conductor (55) running through the recess in the basic element (15) by means of the bore in the extension (17),
- the insert (13) is made from an electrically conductive material
- the insert (13) forms an outer conductor connected to the connection (25c) for the outer conductor, and
- the insert (13) is electrically isolated in relation to the conductor (55) and the sleeve (3).

10. Adapter as claimed in Claims 3 and 9, wherein
- the basic element (15) connected to the connection (25c) for the outer conductor is connected to the corresponding connection (29) via a conductive track (35c) in the printed circuit board (33), and
- the conductive track (35c), which connects the conductor (55) - connected to the connection (25c) for the inner conductor - to the corresponding connection (29) is implemented in the printed circuit board (33).

11. Adapter as claimed in Claim 10, wherein the basic element (15) is connected via a connection cable (59) to the corresponding conductive track (35c) of the printed circuit board (33).

12. Adapter as claimed in Claim 1, wherein the insert (13) and the sleeve (3) are electrically isolated in relation to one another.

13. Adapter as claimed in Claim 12, wherein
- the basic element (15) is surrounded on the outside by a gap that is filled with the potting (49), and wherein
- an isolator (57) is provided between the sleeve (3) and the insert (13), wherein said isolator (57) isolates the front wall (7) of the sleeve (3) in relation to the front wall of the basic element (13), and isolates the extension (17) - which runs through the opening in the front wall (7) of the sleeve (3) - in relation to the front wall (7) surrounding the opening.

14. Adapter as claimed in Claim 1, wherein the sleeve (3) filled with the potting (49) is designed as a flame barrier.

15. Field device with an adapter as claimed in one or more of the previous claims and an electronics unit (31a, 31b, 31c) that can be connected to a transmission cable (23a, 23b, 23c) via the adapter.

## Revendications

1. Adaptateur destiné au raccordement d'un câble de transmission (23a, 23b, 23c) à un appareil de terrain, avec
- une douille (3) insérable dans une ouverture de la paroi (1) d'un boîtier de l'appareil de terrain, laquelle douille présente, à l'état inséré, une partie intérieure ouverte en direction du boîtier et une partie intérieure fermée vers l'extérieur, à travers une paroi frontale (7) de la douille (3), et laquelle douille comporte un enrobage (49), qui remplit un espace creux restant dans la douille (3) ;
**caractérisé**
**en ce que** l'adaptateur présente
- un insert (13) inséré dans la douille (3), lequel insert comprend un élément de base (15) disposé dans la douille (3), ainsi qu'un prolongement faisant saillie de la douille (3) à travers une ouverture dans la paroi frontale (7) de la douille (3), et dont son élément de base (15) présente une surface de base, qui est supérieure à une surface de base de l'ouverture dans la paroi frontale (7) de la douille (3),
- un élément de raccordement (19a, 19b, 19c) prévu à une extrémité du prolongement faisant saillie de la douille (3), élément de raccordement auquel le câble de transmission (23a, 23b, 23c) peut être raccordé,
- au moins un conducteur (27a, 27b, 55) raccordé, à travers un perçage réalisé dans le prolongement (17), à une connexion (25a, 25b, 25c) de l'élément de raccordement (19a, 19b, 19c), lequel conducteur est acheminé à travers un évidement de l'élément de base (15), lequel évidement est ouvert en direction de la partie intérieure (5) du boîtier et est adjacent au perçage réalisé dans le prolongement (17).

2. Adaptateur selon la revendication 1, pour lequel
- la douille (3) est constituée d'un matériau résistant à la pression et peut être reliée avec la paroi de boîtier (1) de l'appareil de terrain à travers une liaison mécanique résistant à la pression, et/ou
- l'enrobage (49) est constituée d'un résine époxy ou de silicone.

3. Adaptateur selon la revendication 1, pour lequel
- est prévu une carte de circuit imprimé (33) insérée dans l'adaptateur,
- la carte de circuit imprimé (33) est munie de pistes conductrices (35a, 35b, 35c), et
- chacun des conducteurs (27a, 27b, 55) est relié par l'intermédiaire d'une des pistes conductrices (35a, 35b, 35c) avec une connexion (29) correspondante, via laquelle chaque conducteur (27a, 27b, 55) peut être raccordé à une électronique (31a, 31b, 31c) de l'appareil de terrain.

4. Adaptateur selon la revendication 3, pour lequel le tracé des pistes conductrices (35a, 35b, 35c) est réalisé dans la carte de circuit imprimé (33).

5. Adaptateur selon la revendication 3, pour lequel
- la carte de circuit imprimé (33) est disposée dans l'adaptateur de telle sorte à ce qu'elle soit parallèle à l'axe longitudinal de la douille (3) à travers l'adaptateur, une normale surfacique sur la surface de la carte de circuit imprimé s'étendant perpendiculairement à l'axe longitudinal de la douille (3), et/ou
- la carte de circuit imprimé (33) comprend une première partie (37) insérée dans l'élément de base (15) et une deuxième partie (39), adjacente à la première partie, guidée à travers la douille (3).

6. Adaptateur selon la revendication 4, pour lequel la carte de circuit imprimé (33) comprend deux segments de carte de circuit imprimé (41) s'étendant sur deux faces extérieures opposées de l'élément de base (15), lesquels segments sont reliés avec la deuxième partie (39) de la carte de circuit imprimé (33) et qui sont séparés de la première partie (37) insérée dans l'élément de base (15) par une fente supportant un segment de paroi de l'élément de base (15), laquelle fente s'étend à travers la carte de circuit imprimé (33).

7. Adaptateur selon la revendication 3, pour lequel est prévu un dispositif de fixation, à travers lequel l'élément de base (15) et la carte de circuit imprimé (33) qui y est insérée sont fixés dans la douille (3), lequel dispositif comprend des saillies (47) dépassant des deux côtés de la carte de circuit imprimé (33), qui sont perpendiculaires à l'axe longitudinal de l'adaptateur (3), et une bague de serrage (45) serrée dans une rainure (43) de la douille (3), la bague de serrage (45) étant disposée sur le côté des saillies de carte de circuit imprimé (47) situé à l'opposé de la paroi frontale (7) de la douille (3).

8. Adaptateur selon la revendication 1, pour lequel
- le câble de transmission (21a, 21b) est un câble comprenant au moins un conducteur, et
- est prévu, pour chacun des conducteurs du câble de transmission (21a, 21b), un conducteur (27a, 27b) raccordé, à travers le perçage réalisé dans le prolongement (17), à l'une des connexions (25a, 25b) de l'élément de raccordement (19a, 19b), lequel conducteur s'étend à travers l'évidement de l'élément de base (15), adjacent au perçage réalisé dans le prolongement (17).

9. Adaptateur selon la revendication 1, pour lequel
- le câble de transmission (21c) est un câble coaxial d'une antenne (51) raccordable à l'appareil de terrain, lequel câble coaxial comprend un conducteur intérieur et un conducteur extérieur,
- les connexions (25c) de l'élément de raccordement (19c) comprennent une connexion (25c) pour le conducteur intérieur et une connexion (25c) pour le conducteur extérieur,
- la connexion (25c) pour le conducteur intérieur est raccordée à travers le perçage réalisé dans le prolongement (17) au conducteur (55) s'étendant à travers l'évidement de l'élément de base (15),
- l'insert (13) se compose d'un matériau électriquement conducteur,
- l'insert (13) forme un conducteur extérieur relié avec la connexion (25c) pour le conducteur extérieur, et
- l'insert (13) est isolé électriquement par rapport au conducteur (55) et à la douille (3).

10. Adaptateur selon la revendication 3 et 9, pour lequel
- l'élément de base (15) relié avec la connexion (25c) pour le conducteur extérieur est relié - via une piste conductrice (35c) s'étendant sur la carte de circuit imprimé (33) - avec la connexion (29) correspondante, et
- le tracé de la piste conductrice (35c), qui relie le conducteur (55) - relié avec la connexion (25c) pour le conducteur intérieur - avec la connexion (29) correspondante, est réalisé dans la carte de circuit imprimé (33).

11. Adaptateur selon la revendication 10, pour lequel l'élément de base (15) est relié via un câble de liaison (59) avec la piste conductrice (35c correspondante de la carte de circuit imprimé (33).

12. Adaptateur selon la revendication 1, pour lequel l'insert (13) et la douille (3) sont isolés électriquement l'un par rapport à l'autre.

13. Adaptateur selon la revendication 12, pour lequel
- l'élément de base (15) est entouré à l'extérieur par une fente remplie d'un enrobage (49), et pour lequel
- est prévu, entre la douille (3) et l'insert (13), un isolateur (57) qui isole la paroi frontale (7) de la douille (3) par rapport à la paroi frontale de l'élément de base (13), et isole le prolongement (17) - s'étendant à travers l'ouverture dans la paroi frontale (7) de la douille (3) - par rapport à la paroi frontale (7) entourant l'ouverture.

14. Adaptateur selon la revendication 1, pour lequel la douille (3) remplie avec l'enrobage est conçue en tant que coupe-flammes.

15. Appareil de terrain avec un adaptateur selon l'une ou plusieurs des revendications précédentes et une électronique (31a, 31b, 31c) pouvant être raccordée via l'adaptateur à un câble de transmission (23a, 23b, 23c).
